# EUROPÄISCHE PATENTSCHRIFT

(11) **EP 0 355 172 B1**
(45) Veröffentlichungstag und Bekanntmachung des Hinweises auf die Patenterteilung: **20.07.1994**
(21) Anmeldenummer: 88112829.2
(22) Anmeldetag: 06.08.1988
(51) Int. Cl.: H03J 9/06

(54) **Fernbedienungssystem**
Remote control system
Système de commande à distance

(43) Veröffentlichungstag der Anmeldung: 28.02.1990
(73) Patentinhaber: Deutsche ITT Industries GmbH, 79108 Freiburg (DE)
(72) Erfinder: Micic, Ljubomir, Dipl.-Ing., D-7800 Freiburg (DE); Flamm, Peter Michael, D-7800 Freiburg (DE)

(56) Entgegenhaltungen:
- DE-B- 2 653 113
- GB-A- 2 162 978
- US-A- 4 017 680
- PHILIPS MAGAZINE, 2. Jahrgang, Nr. 1, Frühjahr 1988, Seite 21, Brüssel, BE; & Bedienungsanleitung Farbfernseher 27CI1791, Seite 18
- IEEE TRANS. ON CONS. ELECTR., Band CE-25, Nr. 5, November 1979, Seiten 731-739, IEEE, New York, US; Y. TSUBOI et al.: "Microcomputer-based remote control system for TV receivers"

## Beschreibung

Die Erfindung betrifft ein Fernbedienungssystem mit einem Fernbedienungsgeber, der eine Sendeeinrichtung für Fernsteuersignale, eine Codierschaltung und manuelle Betätigungseinrichtungen aufweist, und mit einem Fernbedienungsempfänger, der eine Empfangseinrichtung für Fernsteuersignale und eine Decodierschaltung aufweist. Derartige Fernbedienungssysteme finden sich im Bereich der gewerblichen Technik, z.B. bei der Kransteuerung, aber auch zunehmend im privaten Bereich, z.B. im einfachen Fall also Garagentorsteuerung oder als aufwendige Fernbedienung von Fernsehgeräten.

In "IEEE Transactions on Consumer Electronics", Vol. CE-25, November 1979, Seiten 731 bis 739 ist ein Fernbedienungssystem beschrieben, das 16 unterschiedliche Befehle zur Steuerung eines Fernsehers abgeben kann. Die Übertragung selbst erfolgt durch optische Signale im Infrarotbereich. Der Fernbedienungsgeber enthält ein Tastenfeld aus 16 Tasten, deren Betätigung durch eine Mikrocomputer als Codierschaltung und eine Sendeeinrichtung, die eine lichtemittierende Diode (= LED) enthält, eine codierte Folge von Infrarot-Lichtimpulsen auslöst. Diese werden durch den Fernbedienungsempfänger, der sich im Fernsehgerät befindet, mittels einer Empfangseinrichtung, die als Sensor eine photoempfindliche PIN-Diode enthält, aufgenommen. Die Unempfindlichkeit gegenüber Störsignalen auf der Empfängerseite wird durch optische Filter, durch selektive Verstärkung, durch Mittelwertbildung und eine daran angeschlossene Schmitt-Triggerschaltung erreicht, deren Ausgang zur Decodierung der empfangenen Signale auf einen Mikrocomputer geführt ist. Als decodierte Signale erzeugt dieser einzelne Steuersignale, z.B. zur Kanalumschaltung.

Ein Nachteil derartiger Fernbedienungssysteme ist die direkte Zuordnung des einzelnen Fernsteuerbefehls zu jeweils einer Fernsteuertaste, weil mit steigender Anzahl von Steuermöglichkeiten das Tastenfeld entsprechend ebenfalls wächst. Auch die Mehrfachausnutzung der Tasten ist nicht befriedigend, weil die kleinere Anzahl von Tasten durch Unübersichtlichkeit und kompliziertere Befehlseingabe erkauft wird. Der üblicherweise handlich gestaltete Fernbedienungsgeber weist zudem wegen seiner kleinen Bauform kaum Möglichkeiten der symbolartigen Darstellung der einzelnen Funktionen auf - noch viel weniger bei Mehrfachausnutzung des Tastenfeldes. Beim Betrieb von Fernsehempfängern kommt erschwerend hinzu, das die Umgebung relativ dunkel ist, was ein Erkennen kleiner unbeleuchteter Symbole zusätzlich erschwert.

Aus GB-A 2 162 978 ist ein Fernbedienungssystem für Bildschirmanzeigen und Fernsehempfänger bekannt, das mittels eines Fernbedienungsgebers über eine Infrarot-Übertragungsstrecke codierte Menu-Signale überträgt, denen auf den Bildschirm Menu-Felder zugeordnet sind, die eine einfache Auswahl verschiedener Steuerfunktionen ermöglichen. Die Menu-Steuersignale werde über eine manuelle Betätigung entsprechender Mittel, in der Regel Tasten, im Geber ausgelöst. Während des Menu-Betriebs ist mittels des Fernbedienungsgebers ein dem optisch angezeigten Menu-Feld zugeordneter Steuerbefehle im Fernbedienungsempfänger auslösbar.

Es ist Aufgabe der in den Ansprüchen gekennzeichneten Erfindung, ein verbessertes Menu-Fernbedienungssystem anzugeben, das einfach bedienbar ist.

Die Lösung dieser Aufgabe besteht darin, ein Fernbedienungssystem mit einer Menu-Steuerung so weiterzubilden, daß mittels einer mechanischen Ausrichtung des Fernbedienungsgebers einzelne, zur Auswahl angebotene Menu-Felder ansteuerbar sind.

Dem Benutzer von Datenverarbeitungsanlage wird bei der Menu-Steuerung eine Auswahl von Befehlen gleichzeitig angeboten, aus denen er den gewünschten aufruft. Im allgemeinen stehen dabei die auszuwählenden Befehle zeilenweise untereinander auf dem Bildschirm, wobei mittels des Cursors der gewünschte Befehl vom Bedienenden anzusteuern ist. Bei Betätigung der Execute-Taste wird der Befehl ausgeführt. Dabei ist von Vorteil, daß die auszuwählenden Befehle auf dem Bildschirm mittels einer Kurzbeschreibung darstellbar sind, was im Tastenfeld nie möglich wäre.

Bei Datenverarbeitungsanlagen erfolgt die Menu-Steuerung zusätzlich zur Befehlseingabe in der jeweiligen Programmiersprache. Eine reine Menu-Steuerung ist dort nicht sinnvoll. Bei Fernbedienungssystemen kann dies jedoch durchaus der Fall sein, wie mindestens ein Ausführungsbeispiel nach der Erfindung zeigt, meist ist jedoch eine Kombination aus einer Tasten- und einer Menu-Steuerung vorzuziehen.

Die Erfindung wird nun anhand der Figuren der Zeichnung näher erläutert.
Fig. 1 zeigt als ein Ausführungsbeispiel der Erfindung schematisch im Blockschaltbild einen Fernbedienungsgeber und einen Fernbedienungsempfänger, der Steuerbefehle abgibt und eine Menu-Felder-Anordnung steuert,
Fig. 2 zeigt schematisch als Blockschaltbild einen anderen Fernbedienungsgeber, der eine Positions-Erkennungseinrichtung bezüglich des Fernbedienungsempfängers enthält,
Fig. 3 zeigt schematisch ein weiteres ebenfalls positionsabhängiges Ausführungsbeispiel des Fernbedienungssystems, wobei der Fernbedienungsempfänger Teil eines Fernsehempfängers ist, und
Fig. 4 zeigt schließlich schematisch als Blockschaltbild die Erzeugung der positionsabhängigen Steuersignale im Fernbedienungsempfänger nach Fig. 3.

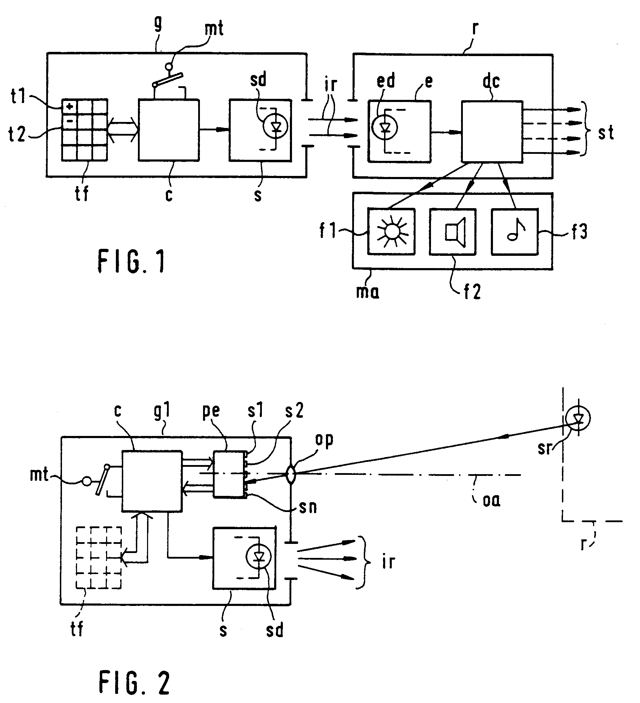

Der schematisch dargestellte Fernbedienungsgeber g nach Fig. 1 enthält das Tastenfeld tf, dessen jeweils gedrückte Taste mittels der Codierschaltung c auf übliche Weise als Pulsfolge codiert und der Sendeeinrichtung s zugeführt ist. Diese enthält die infrarotemittierende Sendediode sd, welche die codierten Tastensignale optisch als Fernsteuersignale ir dem Fernbedienungsempfänger r übermittelt.

Der Fernbedienungsempfänger r enthält in seinem Eingang die Empfangseinrichtung e, die mittels der infrarotempfindlichen Empfängerdiode ed die Fernsteuersignale ir in elektrische Signale umwandelt, die mittels der Decodierschaltung dc in die verschiedenen Steuerbefehle st umgewandelt werden. An die Decodierschaltung dc sind ferner die verschiedenen Menu-Felder f1 bis f3 angeschlossen, die innerhalb der Menu-Felder-Anordnung ma liegen.

Mittels der im Fernbedienungsgeber g enthaltenen Menu-Taste mt ist über die Codierschaltung c dasjenige Fernsteuersignal ir auslösbar, das den Fernbedienungsempfänger r in den Menu-Betrieb schaltet. Dabei werden dem Bedienenden die in den Menu-Feldern mit Symbolen dargestellten Steuerfunktionen zur Auswahl angeboten. Entsprechend der Cursor-Funktion beginnt das dabei jeweils angesprochene Menu-Feld zu blinken oder hebt sich sonstwie von den anderen Menu-Feldern ab. Wird z.B. durch Blinken des Sonnensymbols auf dem ersten Menu-Feld f1 die Bereitschaft zur Helligkeitsänderung angezeigt, jedoch die Änderung der Lautstärke gewünscht, dann wird durch nochmalige Betätigung der Menu-Taste das zweite Menu-Feld f2 angesteuert und damit die Bereitschaft zur Lautstärkeänderung aktiviert. Mittels der im Tastenfeld tf enthaltenen Plus- und Minustaste t1, t2 kann dann die gewünschte Lautstärkenänderung ausgelöst werden.

Der Wechsel der Menu-Felder f1 bis f3 kann eventuell aber auch über Richtungs-Tasten, über einen miniaturisierten Steuerknüppel, über eine Kugel- oder Maussteuerung oder über eine andere mechanische Steuereinrichtung in Verbindung mit der Codierschaltung c erfolgen.

Die Beendigung der Menu-Steuerung erfolgt beispielsweise durch eine zeitlich verlängerte Betätigung der Menu-Taste mt oder durch Ansteuerung eines Menu-Aus-Feldes. Eine automatische Beendigung des Menu-Betriebs besteht darin, daß nach einer vorgegebenen Zeitdauer, in der die Menu-Taste mt nicht betätigt wurde, der Menu-Betrieb automatisch ausgeschaltet wird.

In Fig. 2 ist schematisch dargestellt, wie in einem anderen Fernbedienungsgeber g1 nach der Erfindung eine Positions-Erkennungseinrichtung pe der Menu-Steuerung dient. Und zwar wird dabei die relative Lage einer infrarotemittierenden Signalquelle sr im Fernbedienungsempfänger r zu derjenigen optischen Achse oa ausgewertet, die durch die Positions-Erkennungseinrichtung pe und die Optik op im Fernbedienungsgeber g1 bestimmt ist. Dabei wird die Signalquelle sr mittels der Optik op auf der Posistions-Erkennungseinrichtung pe abgebildet, die auf ihrer Oberfläche eine unterteilte Sensorfläche mit n Sensorelementen s1 bis sn enthält. Deren Anzahl und deren Anordnung entspricht der zugehörigen in Fig. 2 nicht dargestellten Menu-Felder-Anordnung.

Das angesprochene Sensorelement s1 bis sn erzeugt mittels der Codierschaltung c ein Ansteuersignal für die Sendeeinrichtung s. Die von der Sendediode sd abgebenen Fernsteuersignale ir enthalten somit codiert als Information, welches der n Sensorelemente s1 bis sn aktiviert ist.

Durch die Steuerung über die Richtungsabhängigkeit vereinfacht sich die Auswahl der gewünschten Steuerungsfunktion. Für viele Fernsteuerungsaufgaben kann daher das gestrichtelt dargestellte Tastenfeld tf entfallen. Mittels der an der Codierschaltung c angeschlossenen Menu-Taste mt kann dann die jeweils "angeblinkte" Funktion ausgelöst werden. Die Plus- und Minustasten t1, t2 von Fig. 1 werden dann jeweils durch ein eigenes Menu-Feld ersetzt.

Die Erkennung und Auswertung der Richtungsabhängigkeit kann jedoch mittels einer geeigneten Auswerteschaltung auch im Ferbedienungsempfänger erfolgen, z.B. indem den Menu-Feldern jeweils eine Sensor-Diode zugeordnet ist, die durch einen gezielten Infrarotimpuls aus dem Fernbedienungsgeber angeblinkt werden kann. Eine andere Möglichkeit zur Auswertung der Richtungsabhängigkeit ist in der Auslegeschrift DE-B 26 53 113 (= US-A 4 210 329) beschrieben, die eine Fernsehspielanordnung zeigt, bei der mittels eines optisch elektrischen Zielsuchgerätes ein auf dem Bildschirm wandernder Leuchtfleck abzuschießen ist. Das Ausgangssignal des Zielsuchgerätes wird dabei drahtlos zum Fernsehempfänger übertragen und dort einer Auswerteschaltung zugeführt.

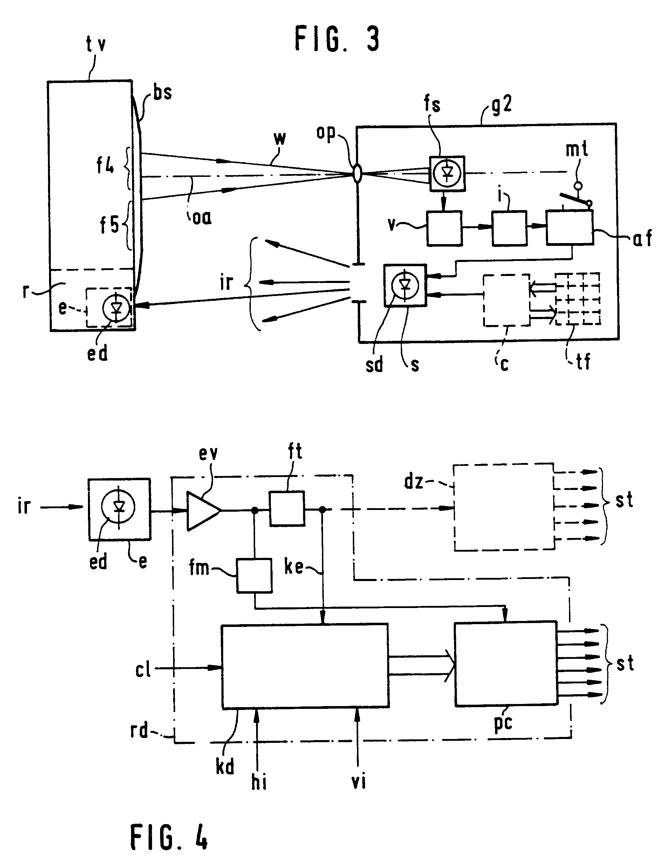

In Fig. 3 ist schematisch als Blockschaltbild ein weiteres Ausführungsbeispiel des erfindungsgemäßen Fernbedienungssystems gezeigt, das mit einem Fernsehempfänger tv zusammengeschaltet ist. Zur Menu-Steuerung wird dabei ebenfalls die relative Lage des Fernbedienungsgebers g2 zum Fernbedienungsempfänger r und damit zum Fernsehempfänger tv ausgewertet. Dabei werden mindestens Teile des Bildschirms bs zur Darstellung verschiedener Menu-Felder verwendet. Diese Menu-Felder, eventuell mit Symboldarstellung, werden mittels eines Zeichengenerators im Fernsehempfänger tv erzeugt. In Fig. 3 sind auf dem Bildschirm bs schematisch zwei Menu-Felder f4, f5 dargestellt.

Der Fernbedienungsgeber g2 enthält eine fotoempfindliche Empfangseinrichtung fs, welche bei geeigneter Ausrichtung auf die vom Bildschirm bs dargestellten Menu-Felder f4, f5 anspricht. Der Empfangsbereich umfaßt dabei lediglich den kleinen Raumwinkel w in Richtung der optischen Achse oa, die durch die Richtung der fotoempfindlichen Empfangseinrichtung fs und die Optik op gebildet wird. Der Raumwinkel w ist dabei so gewählt, daß bei normalem Fernseh-Betrachtungsabstand nicht mehr als ein einziges Menu-Feld f4, f5 erfaßt wird. Bei einem zu kleinen Raumwinkel w wird die Bedienung indessen unsicher.

Die von der fotoempfindlichen Empfangseinrichtung fs gebildeten elektrischen Signale werden im selektiven Vorverstärker v verstärkt und danach dem Impulsformer i zugeführt, an den ferner die Ablaufsteuerung af, eine einfache Codierschaltung, angeschlossen ist. Diese enthält im einfachsten Fall einen elektronischen Schalter, der durch die Menu-Taste mt bedient wird. Bei geschlossener Menu-Taste mt gelangen somit die von der fotoempfindlichen Empfangseinrichtung fs aufgenommen Signale an die Sendeeinrichtung s und damit an die Sendediode sd. Diese erzeugt die Fernsteuersignale ir, die vom Fernbedienungsempfänger r empfangen und ausgewertet werden; z.B. wird ein Cursor auf dem Bildschirm bs in die zugehörige Bildschirmposition bewegt, wobei der Cursor ebenfalls vom Zeichengenerator erzeugt ist.

Es ist indessen besser, wenn die Menu-Taste mt in Verbindung mit der Ablaufsteuerung af nicht als reiner Schalter wirkt, weil in diesem Fall die Positions-Information nur während der Bedienung der Menu-Taste mt zur Verfügung steht. Besser ist es, wenn die Menu-Taste in Verbindung mit der Ablaufsteuerung af lediglich eine Modifikation des Fernsteuersignals ir bewirkt, die als solche im Fernbedienungsempfänger r sicher erkannt wird, ohne die Positions-Information zu stören. Dies wird auf einfache Weise z.B. dadurch erreicht, daß die Ablaufsteuerung af bei Betätigung der Menu-Taste mt eine Pulsfolge mit einer definierten anderen Frequenz an die Sendeeinrichtung s abgibt und der Fernbedienungsempfänger r Mittel zur deren Erkennung enthält.

In Fig. 3 ist im Fernbedienungsgeber g2 gestrichelt angedeutet, daß zur Menu-Steuerung eine Tasten-Steuerung mit Tastenfeld tf und Codierschaltung c hinzufügbar ist.

In Fig. 4 ist schematisch als Blockschaltbild dargestellt, wie die empfangenen Fernsteuersignale ir im Fernbedienungsempfänger r nach Fig. 3 mittels der Auswerteschaltung rd ausgewertet werden. Die empfangenen Fernsteuersignale ir werden mittels der Empfängerdiode ed in der Empfangseinrichung e in elektrische Signale umgewandelt, die im Vorverstärker ev verstärkt und in der daran angeschlossenen Filterschaltung ft gefiltert werden. Diese ist im wesentlichen nur für Signale mit der Zeilenfrequenz durchlässig, wobei die Gleichlichtanteile oder die Wechsellichtanteile der Raumbeleuchtung unterdrückt werden.

Die im Zeilenraster dargestellten Menu-Felder f4..., vergl. Fig. 3, erzeugen dabei Fernsteuersignale ir, die ebenfalls die charakteristische Zeilenablenkfrequenz enthalten. Dies wird zur Auswertung des jeweils angesteuerten Menu-Feldes f4 ... und damit der jeweiligen Bildschirmposition ausgenutzt, indem das Ausgangssignal der Filterschaltung ft dem Koinzidenzdeketor kd zugeführt wird, der ferner mit den Horizontal- und Vertikalimpulsen hi, vi der Bildschirmsteuerung gespeist ist. In ihm wird festgestellt, in welcher zeitlicher Beziehung zum Elektronenstrahl-Rasterlauf das Koinzidenzdetektor-Eingangssignal ke auftritt.

Der Koinzidenzdektor kd enthält z.B. zwei Zähler, wobei der erste Zähler durch den Horizontal- und der zweite Zähler durch den Vertikalimpuls hi, vi auf Null gesetzt und gestartet wird. Der jeweilige Zählvorgang wird durch das Koinzidenzdetektor-Eingangssignal ke gestoppt und der jeweilige Zählerstand dem Positions-Decodierer pc zugeführt. Der Zähltakt cl ist dabei sinnvollerweise mit dem Takt des o.g. Zeichengenerators gekoppelt. Je nach dem übermittelten Zählerstand bestimmt der Positions-Decodierer, auf welches der Menu-Felder die optische Achse oa des Fernbedienungsgebers g2 zeigt, wobei der zugehörige Steuerbefehl st abgegeben wird, der z.B. den evtl. dargestellten Cursor nachführt oder das entsprechende Menu-Feld blinken läßt.

Wird zusätzlich eine Tasten-Steuerung verwendet, dann wird das Ausgangssignal der Filterschaltung ft entsprechend der Fig. 1 der zusätzlichen Decodierschaltung dz zugeführt, die je nach der zugehörigen Impulsfolge den zugehörigen Steuerbefehl st auswählt. Ferner ist der Vorverstärker ev über die weitere Filterschaltung fm mit dem Positions-Decodierer pc verbunden, um dasjenige Steuersignal st auszulösen, das der von der Menu-Taste mit ausgelösten Pulsfolge in Verbindung mit dem jeweiligen Menu-Feld zugeordnet ist.

Zur besseren Störunterdrückung kann der Positions-Decodierer pc so ausgebildet sein, daß ihm das richtige Signal mehrfach angeboten werden muß, bevor er einen Steuerbefehl st auslöst. Dies ermöglicht eine nichtdargestellte Freigabeschaltung, die den Steuerbefehl st nur dann freigibt, wenn das jeweilige Menu-Feld ausreichend oft angesprochen ist. Dies ist mittels eines Vor-Rückwärtszählers feststellbar.

In den Ausführungsbeispielen nach Fig. 1 bis 3 ist jeweils nur eine einzige Menu-Taste mt dargestellt. Weitere, aber nicht dargestellte Ausführungsbeispiele des Fernbedienungssystem weisen indessen nicht nur eine Menu-Taste mt auf, sondern mehrere, indem zusammengehörende Steuerbefehle mittels jeweils einer eigenen Menu-Taste ansteuerbar sind. Bei Fernsehempfängern z.B. eine Menu-Taste für die Kanalumschaltung, eine Menu-Taste für die Helligkeitssteuerung, eine Menu-Taste für die Farbsättigungseinstellung und schließlich eine Menu-Taste für die Lautstärkeeinstellung, wobei in allen vier Fällen eine gemeinsame Plus- oder Minustaste bzw. ein gemeinsames Plus- oder Minus-Menufeld der jeweiligen Einstellung dient.

Die Kanalumschaltung im Menu-Betrieb ist bei der Mehrfachbilddarstellung auf dem Fernsehbildschirm sehr bedienungsfreundlich, weil der Bedienende mit dem Fernbedienungsgeber g1; g2 nur auf das jeweilige interessierende Programm-Feld, das zugleich ein Menu-Feld f4.... ist, zeigen muß. Mit der Menu-Taste mt wird dann das im jeweiligen Menu-Feld f4 ... dargestellte verkleinerte Bild als Hauptprogramm übernommen, also in voller Größe auf dem Bildschirm bs wiedergegeben.

## Patentansprüche

1. Fernbedienungssystem mit einem Fernbedienungsgeber (g; g1; g2), der eine Sendeeinrichtung (sd) für Fernsteuersignale (ir), eine Codierschaltung (c) und manuelle Betätigungseinrichtungen (tf; mt) enthält, und mit einem Fernbedienungsempfänger (r), der eine Empfangseinrichtung (e) für die Fernsteuersignale (ir) und eine Decodierschaltung (dc) enthält, wobei das Fernbedienungssystem folgende Merkmale aufweist:
- der Fernbedienungsgeber (g; g1; g2) enthält Mittel, deren Betätigung den Fernbedienungsempfänger (r) in Menu-Betrieb schalten,
- während des Menu-Betriebs sind dem Fernbedienungsempfänger mindestens zwei Menu-Felder (f1... f3; f4, f5) zugeordnet, die einzeln mittels des Fernbedienungsgebers (g; g1; g2) ansprechbar sind, wobei das jeweils angesprochene Menu-Feld optisch angezeigt ist,
- während des Menu-Betriebs ist mittels des Fernbedienungsgebers ein dem optisch angezeigten Menu-Feld (f1) zugeordneter Steuerbefehl (st) im Fernbedienungsempfänger (r) auslösbar, und wobei das Fernbedienungssystem
durch folgende Merkmale gekennzeichnet ist:
- die Mittel, deren Bestätigung den Menu-Betrieb bewirken, enthalten mindestens eine Menu-Taste (mt), und
- während des Menu-Betriebs ist das jeweils anzusprechende Menu-Feld durch eine manuelle Ausrichtung des Fernbedienungsgebers (g1) bestimmt, indem die auf den Fernbedienungsempfänger (r) bezogene räumliche Lage, des Fernbedienungsgebers (g1) laufend in diesem mittels einer Positions-Erkennungseinrichtung (pe) festgestellt ist, deren Ausgangssignale der Codierschaltung (c) zur Bildung der Fernsteuersignale (ir) zugeführt sind, wobei zur Ansteuerung der Positions-Erkennungseinrichtung (pe) eine Signalquelle (sr) im Fernbedienungsempfänger (r) dient.

2. Fernbedienungssystem nach Anspruch 1, dadurch gekennzeichnet, daß während des Menu-Betriebs das jeweils anzusprechende Menu-Feld (f4...) durch manuelle Ausrichtung des Fernbedienungsgebers (g2) bestimmt ist, indem die auf den Fernbedienungsempfänger (r) bezogene räumliche Lage des Fernbedienungsgebers (g2) laufend im Fernbedienungsempfänger (r) mittels einer Auswerteschaltung (rd) ausgewertet wird.

3. Fernbedienungssystem nach einem der Ansprüche 1 bis 2, dadurch gekennzeichnet, daß der Fernbedienungsempfänger (r) Teil eines Fernsehempfängers (tv) ist.

4. Fernbedienungssystem nach Anspruch 3, dadurch gekennzeichnet, daß die Menu-Felder (f4, f5) auf dem Bildschirm (bs) eingeblendet sind und daß das jeweils angesprochene Menu-Feld (f4) auf dem Bildschirm gegenüber dem oder den nicht angesprochenen Menu-Feld(ern) optisch hervorgehoben ist.

5. Fernbedienungssystem nach einem der Ansprüche 1 bis 4, gekennzeichnet durch folgende Merkmale:
- der Fernbedienungsgeber (g2) enthält eine photoempfindliche Empfangseinrichtung (fs) welche einen Raumwinkel (w) in Richtung der optischen Achse (oa) erfaßt, der bei normalem Fernseh-Betrachtungsabstand nicht größer als der einem einzigen Menu-Feld (f4) zuzuordnende Raumwinkel ist,
- die Ausgangssignale der photoempfindlichen Empfangseinrichtung (fs) sind mittels eines selektiven Verstärkers (v) eines Impulsformers (i) und einer Ablaufsteuerung (af) über die Sendeeinrichtung (s) dem Fernbedienungsempfänger (r) zugeführt, der mittels eines Koinzidenzdetektors (kd), dem Horizontal- und Vertikalimpulse (hi, vi) der Bildschirmsteuerung zugeführt sind, feststellt, in welcher zeitlicher Beziehung zum Elektronenstrahl-Rasterlauf das mit dem Ausgangssignal der photoempfindlichen Empfangseinrichtung (fs) gekoppelte Koinzidenzdetektor-Eingangssignal (ke) auftritt und
- die Ausgangssignale des Koinzidenzdetektors (kd) sind mittels eines Positions-Decodierers (pc) in die Steuerbefehle (st) umgewandelt.

6. Fernbedienungssystem nach Anspruch 5, dadurch gekennzeichnet, daß die Ablaufsteuerung (af) mit der Menu-Taste (mt) gekoppelt ist und daß durch deren Betätigung das der Sendeeinrichtung (s) zugeführte Signal derart modifiziert wird, daß im Fernbedienungsempfänger (r) diese Modifikation sicher erkannt wird.

7. Fernbedienungssystem nach Anspruch 6, dadurch gekennzeichnet, daß der Menu-Betrieb durch die Ansteuerung eines separaten Menu-Aus-Feldes beendet wird.

8. Fernbedienungssystem nach Anspruch 6, dadurch gekennzeichnet, daß der Menu-Betrieb nach einer vorgegebenen Zeitdauer, in der die Menu-Taste (mt) nicht betätigt wurde, automatisch beendet wird.

9. Fernbedienungssystem nach einen der Ansprüche 1 bis 8, dadurch gekennzeichnet, daß zusammengehörende Steuerbefehle mittels jeweils einer eigenen Menu-Taste (mt) ansteuerbar sind.

## Claims

1. A remote-control system with a remote-control transmitter (g; g1; g2) comprising a transmitting device (sd) for remote-control signals (ir), an encoder circuit (c), and manual control elements (tf; mt), and with a remote-control receiver (r) comprising a receiving device (e) for the remote-control signals (ir) and a decoder circuit (dc), the remote-control system having the following features:
- The remote-control transmitter (g; g1; g2) includes means whose operation switches the remote-control receiver (r) to the menu mode;
- during the menu mode, the remote-control receiver is assigned at least two menu fields (f1...f3; f4, f5) which are individually selectable by means of the remote-control transmitter (g; g1; g2), with the respective selected menu field being indicated visually, and
- during the menu mode, a control command (st) assigned to the visually indicated menu field (f1) can be triggered in the remote-control receiver (r) by means of the remote-control transmitter, and the remote-control system
being characterized by the following features:
- The means whose operation cause the switching to the menu mode include at least one menu key (mt), and
- during the menu mode, the respective menu field to be selected is determined by manual alignment of the remote-control transmitter (g1), with the relative position of the remote-control transmitter (g1) with respect to the remote-control receiver (r) being continuously determined in the remote-control transmitter (g1) by means of a position-sensing device (pe) whose output is fed to the encoder circuit (c) for forming the remote-control signals (ir), the position-sensing device (pe) being driven by a signal source (sr) in the remote-control receiver (r).

2. A remote-control system claimed in claim 1, characterized in that during the menu mode, the menu field to be selected (f4...) is determined by manual alignment of the remote-control transmitter (g2), with the relative position of the remote-control transmitter (g2) with respect to the remote-control receiver (r) being continuously evaluated in the remote-control receiver (r) by means of an evaluating circuit (rd).

3. A remote-control system claimed of claim 1 or 2, characterized in that the remote-control receiver (r) is part of a television receiver (tv).

4. A remote-control system as claimed in claim 3, characterized in that the menu fields (f4, f5) are displayed on the screen (bs), and that the selected menu field (f4) on the screen is set off visually from the nonselected menu field(s).

5. A remote-control system as claimed in any one of claims 1 to 4, characterized by the following features:
- The remote-control transmitter (g2) includes a photosensitive receiving device (fs) whose field of view is a solid angle (w) in the direction of the optical axis (oa) which, at a normal television viewing distance, is not greater than the solid angle to be assigned to a single menu field (f4);
- the output of the photosensitive receiving device (fs) is fed via a selective amplifier (v), a pulse shaper (i), a sequence controller (af), and the transmitting device (s) to the remote-control receiver (r), which determines, by means of a coincidence detector (kd) fed with horizontal and vertical pulses (hi, vi), the time relationship of the coincidence detector input signal (ke), which is locked to the output signal of the photosensitive receiving device (fs), to the horizontal sweep, and
- the output signals from the coincidence detector (kd) are converted into the control commands (st) by means of a position decoder (pc).

6. A remote-control system as claimed in claim 5, characterized in that the sequence controller (af) is coupled with the menu key (mt), and that a depression of the menu key (mt) causes the signal fed to the transmitting device (s) to be modified in such a manner that said modification is reliably recognized in the remote-control receiver (r).

7. A remote-control system as claimed in claim 6, characterized in that the menu mode is terminated by selecting a separate menu-off field.

8. A remote-control system as claimed in claim 6, characterized in that the menu mode is terminated automatically after a predetermined period of time in which the menu key (mt) was not operated.

9. A remote-control system as claimed in any one of claims 1 to 8, characterized in that control commands belonging together are selectable by means of a single menu key (mt) assigned thereto.

## Revendications

1. Système de télécommande, comprenant un émetteur de télécommande (g ; g1 ; g2), comportant un dispositif (sd) émetteur de signaux de télécommande (ir), un circuit de codage (c) et des dispositifs de manoeuvre manuelle (tf ; mt), et un récepteur de télécommande (r) comportant un dispositif (e) émetteur de signaux de télécommande (ir) et un circuit de décodage (dc), le système de télécommande comportant les particularités suivantes :
- l'émetteur de télécommande (g ; g1 ; g2) contient des moyens dont l'actionnement commute le récepteur de télécommande (r) en fonctionnement en menu,
- pendant le fonctionnement en menu, il est associé au récepteur de télécommande au moins deux menus (f1... f3 ; f4, f5) qui peuvent être recherchés individuellement au moyen de l'émetteur de télécommande (g ; g1 ; g2), le menu chaque fois recherché étant affiché optiquement,
- pendant le fonctionnement en menu, un ordre de commande (st) associé au menu (f1) affiché optiquement peut être activé dans le récepteur de télécommande (r) au moyen de l'émetteur de télécommande,
le système de télécommande étant caractérisé par les particularités suivantes :
- les moyens dont l'actionnement provoque le fonctionnement en menu comportent au moins une touche de menu (mt) et,
- pendant le fonctionnement en menu, le menu devant chaque fois être recherché est déterminé au moyen d'une orientation manuelle de l'émetteur de télécommande (g1), la position spatiale de l'émetteur de télécommande (g1) vis-à-vis du récepteur de télécommande (r) étant relevée d'une manière continue dans cet émetteur de télécommande (g1) au moyen d'un dispositif de reconnaissance de position (pe) dont les signaux de sortie sont envoyés au circuit de codage (c) en vue de former les signaux de télécommande (ir), tandis qu'une source de signaux (fr) située dans le récepteur de télécommande (r) sert à commander le dispositif de reconnaissance de position (pe).

2. Système de télécommande suivant la revendication 1, caractérisé en ce que, pendant le fonctionnement en menu, le menu (f4...) chaque fois recherché est déterminé au moyen d'une orientation manuelle de l'émetteur de télécommande (g2), la position spatiale de l'émetteur de télécommande (g2) vis-à-vis du récepteur de télécommande (r) étant exploitée d'une manière continue dans le récepteur de télécommande (r) au moyen d'un circuit d'exploitation (rd).

3. Système de télécommande suivant l'une des revendications 1 et 2, caractérisé en ce que le récepteur de télécommande (r) constitue une partie d'un récepteur de télévision (tv).

4. Système de télécommande suivant la revendication 3, caractérisé en ce que les menus (f4, f5) sont diaphragmés sur l'écran (bs) et en ce que le menu (f4) chaque fois recherché ressort optiquement sur l'écran vis-à-vis du ou des menus non recherchés.

5. Système de télécommande suivant l'une des revendications 1 à 4, caractérisé par les particularités suivantes :
- l'émetteur de télécommande (g2) contient un dispositif récepteur photosensible (fs) qui capte, suivant la direction de l'axe optique (oa), un angle solide (w) qui, pour une distance normale d'observation de télévision, n'est pas supérieur à l'angle solide devant être associé à un menu (f4) unique,
- au moyen d'un amplificateur sélectif (v) d'un circuit de mise en forme (i) et d'une commande d'exécution (af) et par l'intermédiaire du dispositif émetteur (s), les signaux de sortie du dispositif récepteur photosensible (fs) sont envoyés au récepteur de télécommande (r) qui, au moyen d'un détecteur de coïncidence (kd) auquel des impulsions horizontales (hi) et des impulsions verticales (vi) de la commande d'écran sont envoyées, détermine suivant quelle relation temporelle vis-à-vis du balayage de trame du faisceau électronique arrive le signal d'entrée (ke) du détecteur de coïncidence, accouplé au signal de sortie du dispositif récepteur photosensible (fs), et
- les signaux de sortie du détecteur de coïncidence (kd) sont transformés au moyen d'un décodeur de position (pc) de façon à fournir les ordres de commande (st).

6. Système de télécommande suivant la revendication 5, caractérisé en ce que la commande d'exécution (af) est coupée à la touche de menu (mt) et en ce qu'au moyen d'un actionnement de cette dernière, le signal envoyé au dispositif émetteur (s) est modifié d'une façon telle que cette modification est reconnue d'une manière sûre dans le récepteur de télécommande (r).

7. Système de télécommande suivant la revendication 6, caractérisé en ce que le fonctionnement en menu est interrompu au moyen de la commande d'un affichage de suppression de menu séparée.

8. Système de télécommande suivant la revendication 6, caractérisé en ce que le fonctionnement en menu est interrompu automatiquement après une période préfixée au cours de laquelle la touche de menu (mt) n'a pas été actionnée.

9. Système de télécommande suivant l'une des revendications 1 à 8, caractérisé en ce que des ordres de commande associés peuvent être activés chacun au moyen d'une touche de menu (mt) qui lui est propre.
